# EUROPEAN PATENT APPLICATION

(11) **EP 2 149 897 A1**
(43) Date of publication of application: **03.02.2010**
(21) Application number: 08161546.0
(22) Date of filing: 31.07.2008
(51) Int. Cl.: H01J 37/305, H01J 37/304

(54) **Method for milling and end-pointing a sample**

(71) Applicant: FEI COMPANY, Hillsboro, Oregon 97124-5793 (US)
(72) Inventor: Faber, Pybe, 5602 BS Eindhoven (NL); Geurts, Remco, 5602 BS Eindhoven (NL)
(74) Representative: Bakker, Hendrik

(57) **Abstract**

The invention relates to a method for end-pointing milling of a sample with a Focused Ion Beam apparatus (FIB). Known end-pointing results in interruption of the milling only after the feature of interest is exposed. This implies that for high-speed milling the feature may already be damaged when the milling is stopped. The invention discloses that images are made while milling, and that these images are matched with a 3D model of the sample, so that milling conditions can be changed before the feature is exposed. Milling can then progress at a lower speed, offering better control, or another removal technique, such as gas assisted milling with other gasses, can be used so as to minimize damage to the feature. Hereby the method according to the invention combines high removal rate and delicate control of removed thickness.

It is noted that the invention is also applicable when other removal methods are used, such as e.g. laser ablation.

## Description

The invention relates to a method for bringing a sub-surface feature of interest of a sample closer to or at the surface, comprising:
- setting operating conditions governing the removal of material from the sample, and
- based on a model of the sample defining a sub-surface feature of interest, and
repeatedly
- removing a surface layer from the sample using said operating conditions,
- forming an image of the exposed surface, and
- making a decision to change the operating conditions;

This method is disclosed in International Publication No. WO2006/050613A1.

In a Focused Ion Beam apparatus (FIB) a finely focused ion beam is scanned over the surface of a sample. Where the ion beam impinges on the sample material is sputtered or milled from the sample, thereby machining the sample. Secondary radiation in the form of e.g. secondary electrons is emitted from the sample in response to the irradiation. By detecting this radiation an image of the surface of the sample may be generated.

The aforementioned publication discloses that, in order to bring a sub-surface feature, such as a metallization layer of a semiconductor sample, to the surface, the sample is machined in a FIB. During the milling images are formed from the exposed surface. The operator of the instrument, observing the images formed, halts the milling process when the feature of interest is exposed.
The publication provides a method to detect the feature of interest with a greater sensitivity once the feature is exposed. This is achieved by displaying not only images, in which each pixel has a different intensity, but also providing intensity plots of e.g. a line. Further improvement is achieved by signal data processing, resulting in e.g. showing changes in intensity on an exaggerated scale.

It is noted that the images may be formed due to the irradiation with the ion beam, resulting in forming an image while removing material, but may also be the result of inspection with a Scanning Electron Microscope (SEM) column. In a SEM a finely focused electron beam is scanned over the surface of a sample. As electrons are much lighter than atoms, no sputtering occurs. Not only secondary radiation in the form of secondary electrons, but also in the form of back-scattered electrons, X-rays and/or light may be detected from the sample, thereby offering more information of the sample.

The advantage of imaging a sample with a SEM column instead of with a FIB is that an electron beam can typically be focused to a finer focus than an ion beam, and that therefore an image obtained with a SEM typically shows a higher resolution. Another advantage is e.g. that the sample can be studied/imaged without altering the sample, so that prolonged irradiation so as to improve signal-to-noise ratio can be performed without changing the milling speed: the milling conditions and the imaging conditions can be chosen independently.

It is further noted that the milling of the ion beam can be accelerated by admitting an etching gas to the sample. By using an appropriate etchant, milling may also be performed with an electron beam. By using other gasses Ion Beam Induced Deposition (IBID) and Electron Beam Induced Deposition (EBID) may be performed, resulting in local deposition of material. In this way the sample may be locally altered by either etching and/or depositing material.

Instruments with both a FIB column and a SEM column, and provided with means to inject gas, thereby capable of altering a sample and imaging it with high resolution, are commercially available from e.g. FEI Company, Hillsboro, USA.

A disadvantage of the known method is that slices are taken from the surface of the sample until the feature of interest is exposed. For a high throughput the removal rate is preferably high, and therefore the operating conditions used may result in damage of the feature of interest before the removal process is stopped. In this context damage of the feature is the unwanted alteration of the feature, and includes unwanted milling of parts of the feature, and e.g. altering its composition or crystallography by implanting it with ions of the ion beam. Milling at high speed may even result in complete removal of the feature of interest before the milling process is ended when the removed slice completely contains the feature. Obviously this results in destruction of said feature before it can be studied in more detail.
Alternatively a very low removal rate may be used so as not to damage the feature of interest too much when it is brought to the surface. This, however, results in a lower throughput.

There is a need for a method for bringing a feature of interest to the surface combining the possibility of a high removal speed while avoiding damage to the feature of interest.

To that end the method according to the invention is **characterized in that**
- the model is a 3D model comprising volumetric information of the sample,
- the decision to change the operating conditions is based on a comparison of the information obtained from one or more of the formed images with the 3D model of the sample, and
- the operating conditions are changed before the feature of interest is brought at the surface.

The invention is based on the insight that by using a 3D model of the sample, and comparing the images obtained with the 3D model, it can be estimated how far the feature of interest is removed from the surface. By now changing the operating conditions before the feature is brought at the surface, damage of the feature can be prevented.

It is noted that the decision can be based on the comparison of one image with the model, or based on several images of the same surface so as to improve the signal-to-noise ratio by addition or averaging, or it may be based on the comparison of several images of sequentially exposed surfaces, so as to improve the fitting of the position of the images with the 3D model. It is further noted that in the aforementioned publication also a model is used in that the operator expects that a feature, e.g. a metallization layer, can be exposed by removing material. This is however not a 3D model comprising volumetric information.
It is also noted that the method according to the invention is well suited for automated handling of samples.

An additional advantage of the method according to the invention is that, as the feature of interest need not be brought at the surface, the interface of the feature of interest with the material closer to the surface may be studied. Subsequent analysis of the surface, comprising e.g. delicate removal of surface material by milling at low speed or gas-assisted milling with specific gasses, can then give information of the interface.

It is mentioned that end-pointing and 3D modelling are disclosed in "Static vs. dynamic FIB/SEM methods for 3D modelling", B. Van Leer et al., Microsc. Microanal. 13 suppl. 2, 2007, 1506 CD (DOI:10.1017/S1431927607071632). This discloses that a 3D model can be build in a FIB, and further discloses that Simultaneous Patterning and Imaging, also known as SPI, is extremely useful for end-pointing since the milling may be observed real time. However, this publication does not suggest using a 3D model to monitor the progress of the milling.

In an embodiment of the method according to the invention the 3D model is represented by a stack of 2D models of layers of the sample and the comparison of information obtained from one or more images with the 3D model comprises the comparison of one or more images with said stack of 2D models of layers.

By representing the 3D model as a stack of 2D models of layers of the sample, and comparing the image or images with this stack, the progress of the removal process can be tracked. The comparison may include e.g. correlation of the image(s) with the stack of 2D models of layers, and determining the best fit or most probable fit.

It is noted that the progress of the removal may be expressed based on the best fit, but may also be based on interpolating the correlation with the stack of 2D models of layers of the sample.

It is further noted that the progress may also be based on a combination of e.g. the correlation found and the estimated removal rate corresponding to the operating conditions used. This may be attractive when the images correlate with several 2D models of layers, the 2D models of layers showing little variance. This may be the case when the sample shows, at that depth, structures that do not change much as a function of depth.

In another embodiment of the method according to the invention the comparison of the information obtained from one or more images with the 3D model comprises the comparison of a 3D reconstruction of the removed part of the sample with the 3D model.

In this embodiment the information of the images is used to build a 3D reconstruction of the removed part. By now comparing this 3D reconstruction with the 3D model, a fitting of the progress can be obtained, and thereby it can be estimated how far the feature is removed from the surface.

In yet another embodiment of the method according to the invention the method further comprises:
- estimating the distance of the feature of interest from the surface of the sample,
- comparing the estimated distance with a predetermined value, and
- changing the operating conditions when the estimated distance is less than the predetermined value.

By estimating the distance of the feature from the surface, and comparing this distance with a predetermined value, a decision is made to change the operating conditions.

In yet another embodiment of the method according to the invention the removal of the surface layer is the result of ion beam milling, laser ablation, gas assisted ion beam milling, gas assisted electron beam milling or gas assisted laser ablation.

Removal of material using ion beam sputtering is disclosed in the aforementioned publication. Removal using gas assisted ion beam etching and gas assisted electron beam etching are known to the person skilled in the art. Other techniques known per se are laser ablation and gas assisted laser ablation, also known as chemically assisted laser ablation.

In still another embodiment of the method according to the invention comprises lowering the speed normal to the surface with which material can be removed from the sample.

To avoid damage of the feature the speed of removal can be lowered. Using ion beam milling or gas assisted ion beam etching this lowering may be achieved by e.g. lowering the current and/or energy of the ion beam, by using other gasses, or an other partial pressure of gasses, another angle of the ion beam to the surface, etc. Similar effects are known for gas assisted electron beam etching.
Also enlarging the scanned area that is milled or etched (resulting in a reduced current density) may be used: although the rate at which material is removed (volumetrically) does not change, the speed normal to the surface is lowered because the area is enlarged.
Using laser ablation the energy per pulse can be lowered, or the colour of the laser may be changed, or the diameter of the focus may be changed. Gas assisted laser ablation may take advantage of different chemistry or different partial pressures to achieve a change in removal rate.

It is noted that changing the operating conditions may include a change resulting in another selectivity of the removal rates for different materials.

In yet another embodiment of the method according to the invention the imaging comprises scanning a focused electron beam or ion beam over the sample.

The images may be formed by an ion beam, forming the image while removing material, or it may be formed using a SEM column. The use of a SEM column has e.g. the advantage that milling speed and image quality may be chosen independently.

It is noted that the SEM image can be acquired when milling is interrupted, but also during milling. The latter method is e.g. disclosed in the earlier cited "Static vs. dynamic FIB/SEM methods for 3D modelling", B. Van Leer et al., Microsc. Microanal. 13 suppl. 2, 2007, 1506 CD (DOI:10.1017/S1431927607071632).

In still another embodiment of the method according to the invention the imaging is performed using a scanning probe microscope.

A Scanning Probe Microscope (SPM) typically forms an image by rastering a stylus over the sample. SPM is the generic name for a family of instruments including, but not limited to, the Atomic Force Microscope, Scanning Tunneling Microscope, and the Scanning Near Field Optical Microscope.

In yet another embodiment of the method according to the invention the model is determined using an optical microscope or using X-ray tomography.

The model may be based on earlier inspection of the sample with other techniques, such as optical inspection with e.g. a microscope, a confocal laser scanning microscope, or X-ray tomography

In yet another embodiment of the method according to the invention the 3D model is based on a CAD model.

CAD models are often available for e.g. semiconductor samples. The person skilled in the art, knowing e.g. the differences in secondary emission coefficients for the different materials in the CAD model, is then able to generate a 3D model to be matched with the images obtained during milling.

In still another embodiment of the method according to the invention the sample is a vitrified sample and, at least after changing the operating conditions, material is removed by sublimation.

A method of bringing features in a vitrified sample to the surface is disclosed in European Patent No. EP1394834. Milling with a FIB is used to expose the feature, and sublimation is used to improve the observable details. By end-pointing the milling operation based on a 3D model of the sample, exposure of the feature during milling is avoided, and therewith any related damaging of the sample.

The invention is now described with reference to figures in which identical reference numerals denote corresponding elements. Here:
figure 1 schematically shows a sample with an indication of the different layers to be removed,
Figure 2A-2F schematically show different images obtained from the surface after that different slices are removed.

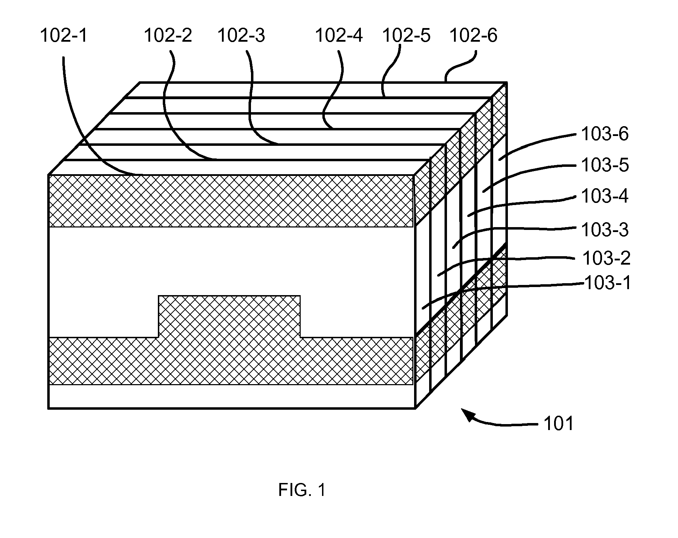

Figure 1 schematically shows a sample 101 with a surface 102-1. Surface layer 102-1 is imaged and forms the basis for the 3D reconstruction of the removed part of the sample. After making the image with e.g. an electron beam and using e.g. a secondary electron detector, and adding the image to the 3D reconstruction dataset, a surface layer 103-1 is removed by e.g. ion beam milling. This brings the surface layer 102-2 to the surface, so that an image can be made of this layer, to be added to the dataset of the 3D reconstruction. This process of imaging a layer 102-i and removing a layer 103-i can be repeated until a feature of interest is brought at the surface.

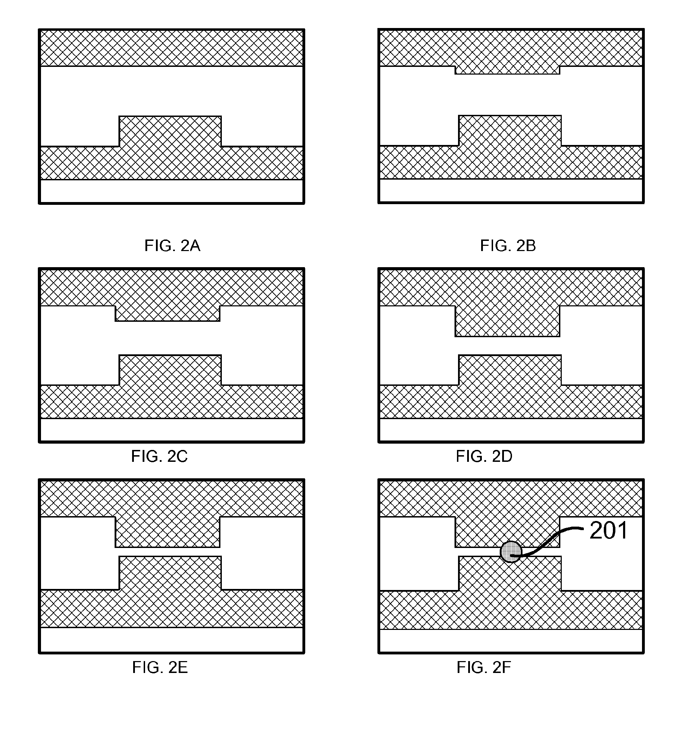

Figure 2A-2F schematically show different images obtained from the surface of the sample after removing different slices. A first image 2A corresponds to the first surface 102-1, the second image 2B with the second surface 102-2, and so forth. As shown in figure 2F a feature of interest 201 becomes exposed after removing layers 103-1, 103-2, 103-3, 103-4, 103-5. In the prior art methods end-pointing can only be executed after imaging surface plane 102-6, corresponding to figure 2F. This implies that the feature is exposed and at least partly damaged by the removal process.

By comparing the images obtained with e.g. 2D models derived from the 3D model of the sample, the 2D models corresponding to models of layers of the sample, it is estimated how far feature 201 is removed from the surface. Before exposing the feature the milling rate can be adjusted/reduced so that feature 201 is not or hardly damaged by the milling process. The comparison can be made by looking for a best fit, so that the position is estimated to coincide with one of the 2D models, but is may also be based on interpolation between two 2D models, resulting in a more accurate estimate of the position of the image with respect to the model.

As known to the person skilled in the art a multitude of comparison methods are known. These can be based on comparing 2D pictures, using e.g. correlation, but may be based on different comparisons. To be mentioned are:
- estimating the amount of a certain material at the surface based on detecting X-rays emitted from the surface and comparing this with the model,
- estimating the amount of a certain material at the surface based on detecting back-scattered electrons emitted from the surface and comparing this with the model,
- detecting the presence of markers and comparing their positions with the model.

It is noted that, as previously mentioned, the reduction in removal rate can be the result of other gas pressures/mixtures, other techniques (ion beam milling instead of laser ablation), etc. Many of these techniques show selectivity, that is: certain materials are eroded quicker than others. Even crystallographic orientation may cause large differences in etch rate for some operating conditions and little difference for other operating conditions. Tuning the operating conditions can thus be done in a variety of ways, and the choice of optimum operation conditions depends on knowledge of the instrument and knowledge of the sample.

It is further noted that the method according to the invention, in which a feature of interest need not be exposed, is especially suited for preparing Transmission Electron Microscope (TEM) lamella subjected to tomography: when making a TEM tomogram: the feature of interest must be located in the lamella, and should not be exposed.

It is also noted that the model used for the sample being machined can be based on images earlier obtained from a presumably similar sample that was machined. The images obtained while machining the similar sample can be stored as the stack of 2D models of layers of the sample. Comparing now reduces to comparing the images of the sample being machined with the stored images from the similar sample.

## Claims

1. Method for bringing a sub-surface feature of interest of a sample closer to or at the surface, comprising:
• setting operating conditions governing the removal of material from the sample, and
• based on a model of the sample defining a sub-surface feature of interest, and
repeatedly
• removing a surface layer from the sample using said operating conditions,
• forming an image of the exposed surface, and
• making a decision to change the operating conditions;
**characterized in that**
• the model is a 3D model comprising volumetric information of the sample,
• the decision to change the operating conditions is based on a comparison of the information obtained from one or more of the formed images with the 3D model of the sample, and
• the operating conditions are changed before the feature of interest is brought at the surface.

2. The method of claim 1 in which the 3D model is represented as a stack of 2D models of layers of the sample and the comparison of the information obtained from one or more images with the 3D model comprises the comparison of one or more images with said stack of 2D models of layers of the sample.

3. The method of claim 1 in which the comparison of the information obtained from one or more images with the 3D model comprises the comparison of a 3D reconstruction of the removed part of the sample with the 3D model.

4. The method of any of the preceding claims further comprising:
• estimating the distance of the feature of interest from the surface of the sample,
• comparing the estimated distance with a predetermined value, and
• changing the operating conditions when the estimated distance is less than the predetermined value.

5. The method of any of the preceding claims in which the removal of the surface layer is the result of ion beam milling, laser ablation, gas assisted ion beam milling, gas assisted electron beam milling or gas assisted laser ablation.

6. The method any of the preceding claims in which changing the operating conditions comprises lowering the speed normal to the surface with which material can be removed from the sample.

7. The method of any of the preceding claims in which the imaging comprises scanning a focused electron beam or ion beam over the sample.

8. The method of any of the preceding claims in which the imaging is performed using a scanning probe microscope.

9. The method of any of the preceding claims in which the model is determined using an optical microscope, a confocal laser scanning microscope or using X-ray tomography.

10. The method of any of the preceding claims in which the model is based on a CAD model.

11. The method of any of the preceding claims in which the sample is a vitrified sample and, at least after changing the operating conditions, material is removed by sublimation.
